# EUROPEAN PATENT SPECIFICATION

(11) **EP 3 680 988 B1**
(45) Date of publication and mention of the grant of the patent: **23.08.2023**
(21) Application number: 19215290.8
(22) Date of filing: 11.12.2019
(51) Int. Cl.: H01R 13/52, H05K 5/06, H02B 1/00, H01R 13/506, H01R 13/74, H01R 24/60

(54) **ELECTRIC APPARATUS WITH ELECTRIC CONNECTION AND PROTECTION FUNCTION**
ELEKTRISCHE VORRICHTUNG MIT ELEKTRISCHER VERBINDUNG UND SCHUTZFUNKTION
APPAREIL ÉLECTRIQUE AYANT UNE FONCTION DE CONNEXION ET DE PROTECTION ÉLECTRIQUES

(30) Priority: 09.01.2019 CN 201910019863
(43) Date of publication of application: 15.07.2020
(60) Divisional application: 23183247.8
(73) Proprietor: Delta Electronics (Shanghai) Co., Ltd., Shanghai 201209 (CN)
(72) Inventor: Chen, Jianhong, Shanghai, 201209 (CN); You, Peiai, Shanghai, 201209 (CN); Sun, Hao, Shanghai, 201209 (CN)
(74) Representative: Uexküll & Stolberg

(56) References cited:
- EP-A1- 1 024 557
- EP-A1- 2 525 443
- WO-A1-2010/050336
- CN-U- 207 009 780
- DE-A1- 19 933 829
- DE-C2- 19 933 829
- US-A- 4 629 269

## Description

### FIELD OF THE INVENTION

The present invention relates to an electric apparatus.

### BACKGROUND OF THE INVENTION

Nowadays, the assembled structure of an insertion element and a docking element is widely used for transferring electric power or signals between an electric apparatus and an electronic system. For example, the electric apparatus comprises an insertion element and a docking element. The insertion element is located at a lateral side of the electric apparatus. The docking element is electrically connected with the electronic system. The wires of the insertion element are outputted from a wire-outlet end thereof. Moreover, the wires are electrically connected with an electronic component within the casing of the electric apparatus. Since the insertion element has wire-outlet holes and there are vacant spaces between the wires and the inner walls of the wire-outlet holes, some drawbacks occur. When the electric apparatus is applied to a specific environment such as an outdoor low-temperature environment or a high humidity environment, the operation of the electric apparatus may result in moisture because of the high temperature of the electric apparatus and the low temperature of the environment. If the moisture enters the insertion element through the vacant spaces between the wire-outlet ends and the wires, the junction between the internal pins of the insertion element and the wires is readily suffered from a rusting problem or a short-circuited problem. Since the connecting condition and the operating condition are not stable, the conventional electric apparatus is easily damaged.

EP 2 525 443 A1 relates to a vehicle-side connector including a mounting plate which is to be fixed to an outer panel of a vehicle, an inner tube portion which is so provided at the mounting plate as to penetrate through the mounting plate, an outer tube portion which surrounds an outer peripheral side of the inner tube portion over the entire circumference in such a manner as to project from the mounting plate toward the inside of the vehicle and have an open projecting end, a rubber plug which forms a sealed space in the outer tube portion by sealing between wires pulled into the inside of the vehicle from the interior of the inner tube portion and an opening of the outer tube portion, a rubber plug presser which is mounted in the opening of the outer tube portion to retain the rubber plug, an inclined surface which is provided in the sealed space and inclined downwardly toward the outside of the vehicle, a drain channel and a drain port which penetrates though the mounting plate and drains water from the drain channel to the outside of the vehicle. EP 2 525 443 A1 discloses also the preamble of claim 1.

US 4,629,269 A discloses an electrical connector having a unique means for sealing the conductor-receiving end of an electrical connector. The seal is effected by molding a membrane as an integral part of the elastomeric insert or grommet used at the rear of the connector, the membrane having a thickness sufficient to maintain the integrity of the seal over any vacant insert pockets but insufficient to prevent or impair normal and proper insertion of a contact terminated conductor into the connector.

DE 199 33 829 A1 describes a plug construction which has a casing containing several terminal chambers with corresponding terminal insertion passages. A gel is arranged between the chambers and the passages in the casing. Several terminals are connected to the fronts of electric wires and are arranged in the chambers so that they can be inserted and guided through the passages and the gel. The plug construction has a casing containing several terminal chambers, which communicate with the outside of the casing through corresponding terminal insertion passages. A gel is arranged between the chambers and the passages in the casing. The arrangement also includes several terminals. which are connected to the fronts of electric wires. The terminals are arranged in the chambers such that they can be inserted and guided through the passages and the gel. The gel seals the space between the casing and the electric wires. Several guides are provided which are each held at the front of a terminal to be guided through the gel. After the guides have been inserted through the gel, they are forced out through the respective chamber.

EP 1 024 557 A1 discloses a one-piece type waterproof rubber plug which is formed with round insertion holes whose inner surfaces can be held in sealing contact with the outer surfaces of a plurality of wires individually inserted into the insertion holes to protect them from water. Female terminal fittings having a box-shaped connection portion are introduced into the insertion holes. In the inner surfaces of the insertion holes are formed slits in positions corresponding to corner portions of the connection portions. While the female terminal fittings are passing the insertion holes by enlargingly deforming them, the corner portions enter the slits, thereby forcibly opening the slits wider to form clearances. The corner portions advance along the clearances. This prevents the corner portions from damaging or scratching the inner surfaces of the insertion holes. After the passage of the female terminal fittings, the insertion holes elastically narrow to close the clearances, with the result that the lips are held in sealing contact with the outer surfaces of the wires.

WO 2010/050336 A1 describes a seal pressing wall for pressing a mat seal at a seal setting section at the rear of a connector housing. The mat seal is provided integrally with a front face of a rear holder for applying compression force to the mat seal, and both a temporary engagement means for holding the rear holder at a temporary engagement position and a final engagement means for holding the rear holder at a final engagement position are provided between the connector housing and the rear holder. The temporary engagement position and the final engagement position are set such that, when the rear holder is in the temporary engagement position, a space is provided between the mat seal and the seal pressing wall and that, when the rear holder is in the final engagement position, the mat seal is pressed against the seal pressing wall. Lips making strong contact with the outer peripheries of electric wires are provided on the inner peripheries of through holes in the mat seal, and the lips of adjacent through holes are alternately shifted from each other in the direction in which the through holes extend. Terminal can be inserted into the connector housing through the through holes without damaging the mat seal.

CN 207 009 780 U provides a single-ended sealed low pressure plug-in components which includes: socket ontology, pencil and installation panel, the socket ontology includes: the interface end, the interface end has a plurality of interfaces, and installation end, the installation end has: be located the four corners socket mounting hole, be located install distolateral sealed pad and a plurality of socket pencil mounting hole, the terminal surface of interface end is less than the terminal surface of installation end, the installation panel have with interface end matched with via hole, just the installation panel with the installation end warp socket mounting hole seals fixed connection, just the pencil with socket pencil mounting hole seals fixed connection, and its self independent sealing water-proofing effect is good, adopts the be convenient for assembly of pencil of installation from inside to outside.

### SUMMARY OF THE INVENTION

The present disclosure provides an electric apparatus with an electric connection and protection function and a connector of the electric apparatus. The electric apparatus comprises a wall-mount connector. The vacant spaces between the wire-outlet holes of the connector and the wires are sealed. Since the inside and outside of the wall-mount connector are isolated, the waterproof, temperature-resistant and heat-insulation functions can be achieved. Since the junction between the internal pins of the insertion element and the wires is not suffered from a rusting problem or a short-circuited problem, the connecting condition and the operating condition of the electric apparatus are more stable. In such way, the electric apparatus can be applied to the specific environment such as an outdoor low-temperature environment or a high humidity environment.

In accordance with the present invention, an electric apparatus with an electric connection and protection function is provided. The electric apparatus includes a casing, a first connector and at least one electronic component. The casing includes at least one first opening. The first connector is partially embedded in the first opening and fixed on the casing. The first connector includes a first connection body, at least one first wire, a protection device and at least one first pin. The first connection body has a first end and a second end. The at least one first pin is disposed within the first connection body. A first end of the first wire is connected with the corresponding first pin and the first wire is routed from the first end of the first connection body. The protection device is disposed on the first end of the first connection body. The first end of the first connection body and a portion of the at least one first wire are sealed and covered by the protection device. The at least one electronic component is disposed within the casing and electrically connected with a second end of the at least one first wire.

In accordance with an example of the present disclosure, a connector is provided. The connector includes a connection body, at least one pin, at least one wire and a protection device. The connection body has a first end and a second end. The at least one pin is disposed within the connection body. A first end of the wire is connected with the corresponding pin and the wire is routed from the first end of the connection body. The protection device is disposed on the first end of the connection body. The first end of the connection body and a portion of the at least one wire are sealed and covered by the protection device.

In accordance with another example of the present disclosure, a method of fabricating a connector is provided. Firstly, an assembly of a connection body and at least one wire is provided. The connection body has a first end and a second end, and the at least one wire is routed from the first end of the connection body. Then, a protective stopper is formed on the first end of the connection body. Then, a potting wall is formed on the first end of the connection body. The potting wall is connected with and protruded externally from the first end of the connection body to enclose the first end of the connection body, so that the protective stopper is disposed within the potting wall. Then, a protective sealant is filled within the potting wall.

In accordance with another example of the present disclosure, a method of fabricating a connector is provided. Firstly, an assembly of a connection body and at least one wire is provided. The connection body includes a first end and a second end, and the at least one wire is routed from the first end of the connection body. Then, a potting wall is formed on the first end of the connection body. Then, a protective stopper is disposed within the potting wall. Then, a protective cap is coupled with the connection body.

The above contents of the present disclosure will become more readily apparent to those ordinarily skilled in the art after reviewing the following detailed description and accompanying drawings, in which:

### BRIEF DESCRIPTION OF THE DRAWINGS

FIG. 1 is a schematic view illustrating an electric apparatus with an electric connection and protection function according to a first embodiment of the present disclosure;
FIGS. 2A to 2D schematically illustrate a process of fabricating a first connector of the electric apparatus as shown in FIG. 1;
FIG. 3 is a schematic view illustrating an electric apparatus with an electric connection and protection function according to a second embodiment of the present disclosure;
FIG. 4A is a schematic perspective view illustrating the first connector of the electric apparatus as shown in FIG. 3;
FIG. 4B is a schematic exploded view illustrating the first connector as shown in FIG. 4A and taken along another viewpoint;
FIG. 5 is a flowchart illustrating a method of fabricating the first connector of the electric apparatus as shown in FIG. 1;
FIG. 6 is a flowchart illustrating a method of fabricating the first connector of the electric apparatus as shown in FIG. 3; and
FIG. 7 is a flowchart illustrating a method of fabricating the first connector of the electric apparatus as shown in FIG. 3 according to another embodiment of the present disclosure.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

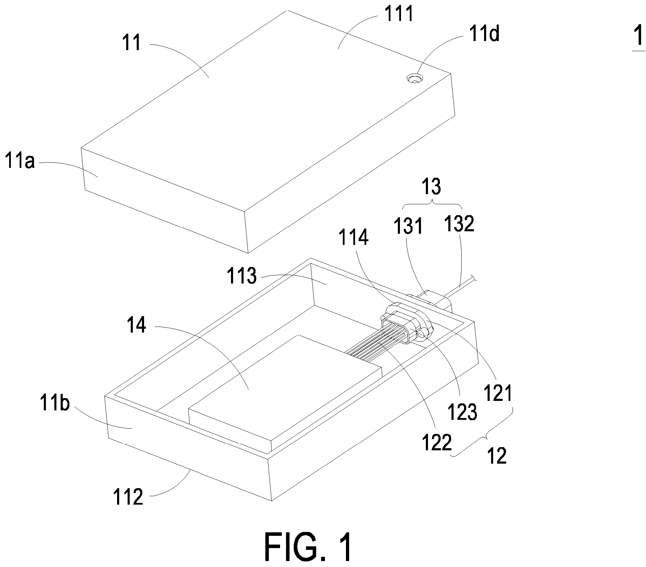

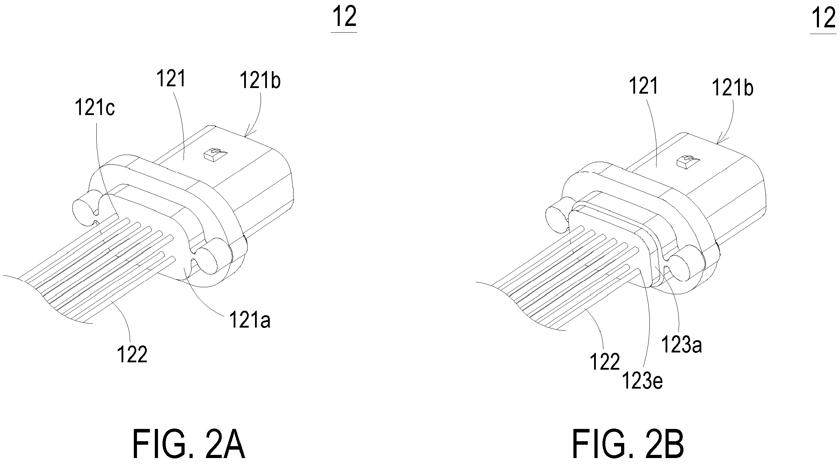

FIG. 1 is a schematic view illustrating an electric apparatus with an electric connection and protection function according to a first embodiment of the present disclosure. FIGS. 2A to 2D schematically illustrate a process of fabricating a first connector of the electric apparatus as shown in FIG. 1. The electric apparatus with an electric connection and protection function 1 (hereinafter referred to as electric apparatus 1) is electrically connected with an electronic system (not shown). The electric apparatus 1 comprises a casing 11, a first connector 12 and an electronic component 14.

The casing 11 comprises a top wall 111, a bottom wall 112, a plurality of lateral walls 113 and at least one first opening 114. The first opening 114 is located at any lateral wall 113, the top wall 111 or the bottom wall 112. Preferably but not exclusively, the first opening 114 is located at the lateral wall 113. In some embodiments, the casing 11 further comprises a ventilation valve 11d. The ventilation valve 11d allows the air in the interior of the casing 11 to flow therethrough and preventing the moisture in the environment from introducing into the interior of the casing 11. In this embodiment, the casing 11 is an assembly of a top cover 11a and a bottom cover 11b. Moreover, the casing 11 further comprises a sealing interface (not shown). Preferably but not exclusively, the sealing interface is located at the junction between the top cover 11a and the bottom cover 11b. Alternatively, the casing 11 is assembled through an installation element with another structure. The installation element is formed as the casing 11 through the sealing interface. In some embodiments, the casing 11 is a fully-sealed casing.

In this embodiment, the first connector 12 is a wall-mount connector. The first connector 12 is penetrated through the first opening 114 of the casing 11 and fixed on the casing 11. The first connector 12 comprises a first connection body 121, at least one first wire 122, a protection device 123 and a plurality of first pins (not shown). In accordance with the present disclosure, the structure of the first connector 12 is specially designed. Hereinafter, the structure of the first connector 12 and a method of fabricating the first connector 12 will be described with reference to FIGS. 2A to 2D.

Please refer to FIGS. 1 and 2A. Firstly, the main part of the first connector 12 is formed. The main part of the first connector 12 comprises the first connection body 121, the at least one first wire 122 and the plurality of first pins (not shown). The first connection body 121 has a first end 121a and a second end 121b. When the first connection body 121 is penetrated through the first opening 114 of the casing 11, the first end 121a of the first connection body 121 is disposed within the casing 11, the second end 121b of the first connection body 121 is located outside the casing 11, and a portion of the first connection body 121 is embedded within the first opening 114 of the casing 11. The first end 121a of the first connection body 121 is served as a wire-outlet end. Moreover, at least one wire-outlet hole 121c is located at the first end 121a of the first connection body 121. The plurality of first pins are disposed within the first connection body 121. Preferably, the at least one first wire 122 comprises a plurality of first wires. A first end of the first wire 122 is connected with the corresponding first pin. Moreover, the junction between the first wire 122 and the corresponding first pin is disposed within the first connection body 121. The first wire 122 is routed from the corresponding wire-outlet hole 121c at the first end 121a of the first connection body 121 (i.e., the wire-outlet end). A second end of the first wire 122 is electrically connected with the electronic component 14. In an embodiment, the electronic component 14 is disposed within the casing 11. Moreover, the electronic component 14 is connected with the second end of the first wire 122. An example of the electronic component 14 includes but is not limited to a circuit board.

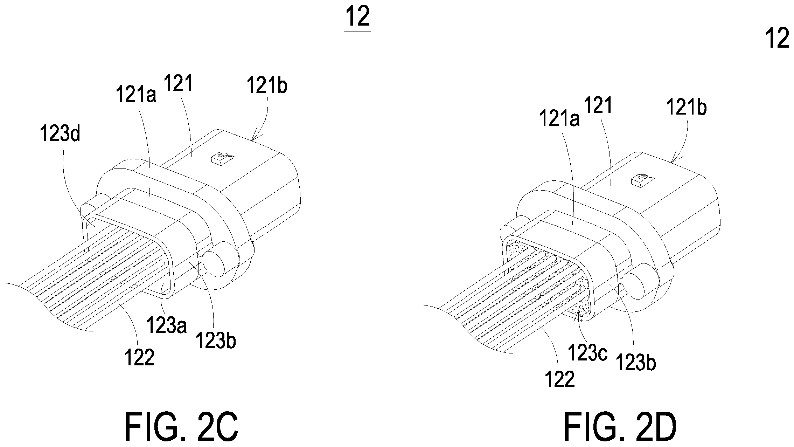

After the main part of the first connector 12 is formed, the protection device 123 is provided and coupled to the main part of the first connector 12. Please refer to FIGS. 2B, 2C and 2D. The protection device 123 is disposed on the first end 121a of the first connection body 121 (i.e., the wire-outlet end). Moreover, the wire-outlet hole 121c and a portion of the first wire 122 close to the first end 121a of the first connection body 121 are covered by the protection device 123. After the vacant space between the wire-outlet hole 121c and the first wire 122 is sealed by the protection device 123, the inside and outside of the first connector 12 is isolated from each other and the junction between the first cable 122 and the first wire 122 can be further isolated from the outside. In an embodiment, the protection device 123 comprises a protective stopper 123a, a potting wall 123b and a protective sealant 123c.

Please refer to FIG. 2B again. The protective stopper 123a is located at the first end 121a of the first connection body 121. A first side of the protective stopper 123a is arranged beside the first end 121a of the first connection body 121, so that the at least one wire-outlet hole 121c is sealed by the protective stopper 123a. The protective stopper 123a comprises at least one second opening 123e. The at least one first wire 122 is penetrated through the corresponding second opening 123e. The wire-outlet hole 121c and a portion of the first wire 122 close to the first end 121a of the first connection body 121 are covered by the protective stopper 123a. The protective stopper 123a is made of an insulating material.

Please refer to FIG. 2C again. Then, the potting wall 123b is connected with and externally protruded from the first end 121a of the first connection body 121. Consequently, the protective stopper 123a is enclosed by the potting wall 123b. In addition, a portion of the first wire 122 is enclosed by the potting wall 123b. Consequently, a vacant space 123d is formed between the potting wall 123b and the first wire 122. The vacant space 123d is located beside the protective stopper 123a. Moreover, the potting wall 123b is made of the insulating material.

Please refer to FIG. 2D again. The protective sealant 123c is filled in the vacant space 123d within the potting wall 123b and located beside a second side of the protective stopper 123a, wherein the second side is opposite to the first side. Moreover, the protective stopper 123a is made of the insulating material.

As mentioned above, the protection device 123 is disposed on the first end 121a of the first connection body 121. Due to the protection device 123, the air within the first connection body 121 of the first connector 12 is not communication with the ambient air. Moreover, because of the protection device 123, no vacant space is formed between the first connection body 121 and the first wire 122 and the junction between the first connection body 121 and the first wire 122 is completely sealed. Since the electric apparatus 1 is not influenced by the ambient moisture, the connecting condition and the operating condition of the electric apparatus 1 are more stable.

In an embodiment, as shown in FIG. 1, the electric apparatus 1 further comprises a second connector 13. The second connector 13 comprises a second connection body 131, at least one second wire 132 and at least one second pin (not shown). The at least one second pin is disposed within the second connection body 131. A first end of the second wire 132 is connected with the corresponding second pin. A second end of the second wire 132 is connected with the electronic system (not shown). The second connector 13 is connected with the electronic system to receive electric power or signals from the electronic system or transmit electric power or signals to the electronic system. The second connector 13 is coupled with the first connector 12. That is, the second connector 13 is coupled with the second end 121b of the first connection body 121 of the first connector 12. Consequently, the at least first pin of the first connector 12 and the corresponding second pin of the second connector 13 are electrically connected with each other. In such way, electric power or signal can be transferred between the electronic system and the electric apparatus 1 through the first connector 12 and the second connector 13. Preferably but not exclusively, the first connector 12 and the second connector 13 are power connectors (e.g., high voltage power connectors) or signal connectors. In case that the first connector 12 is a female connector, the second connector 13 is a male connector. In case that the first connector 12 is a male connector, the second connector 13 is a female connector.

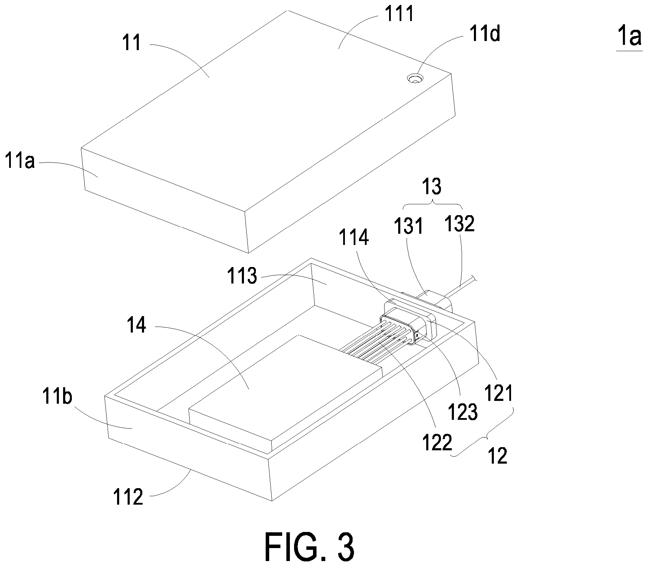

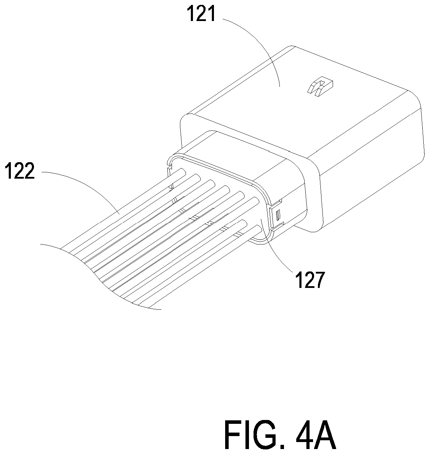

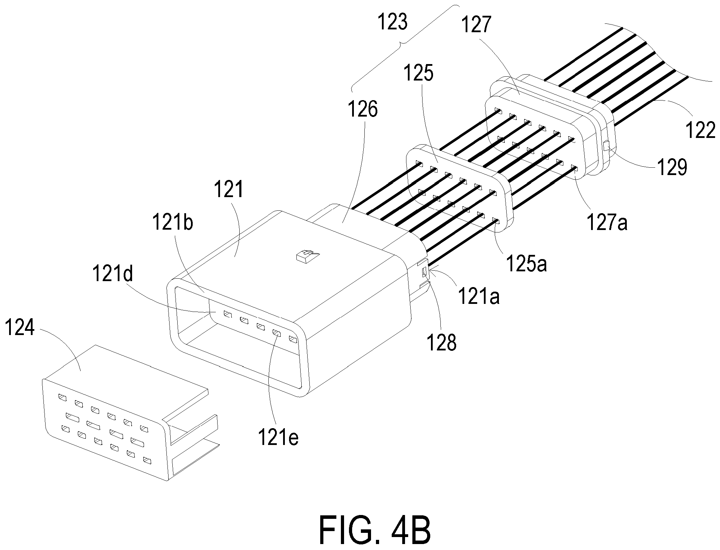

FIG. 3 is a schematic view illustrating an electric apparatus with an electric connection and protection function according to a second embodiment of the present disclosure. FIG. 4A is a schematic perspective view illustrating the first connector of the electric apparatus as shown in FIG. 3. FIG. 4B is a schematic exploded view illustrating the first connector as shown in FIG. 4A and taken along another viewpoint. The electric apparatus 1a comprises a casing 11, a first connector 12, a second connector 13 and an electronic component 14. The structures of the casing 11, the second connector 13 and the electronic component 14 of the electric apparatus 1a are similar to those of the electric apparatus 1 of the first embodiment, and are not redundantly described herein. Component parts and elements corresponding to those of the first embodiment are designated by identical numeral references, and detailed descriptions thereof are omitted. In comparison with the first embodiment, the first connection body 121 and the protection device of the first connector 12 are distinguished.

In this embodiment, the first connection body 121 of the first connector 12 comprises a pin fixture 124 and an inner partition structure 121d. The pin fixture 124 is accommodated within the second end 121b of the first connection body 121 in order to support the at least one first pin. The inner partition structure 121d is disposed within the first connection body 121. The inner partition structure 121d comprises a plurality of through holes 121e. The first pins on the pin fixture 124 are penetrated through the corresponding through holes 121e and extended to the first end 121a of the first connection body 121. Consequently, the junction between the at least one first wire 122 and the corresponding first pin is disposed within the first connection body 121.

In this embodiment, the protection device 123 comprises a protective stopper 125, a potting wall 126 and a protective cap 127.

The protective stopper 125 comprises at least one third opening 125a. The at least one first wire 122 is penetrated through the corresponding third opening 125a. Moreover, the protective stopper 125 is fixed in the first end 121a of the first connection body 121. The protective stopper 125 is made of an insulating material.

The potting wall 126 is connected with and externally protruded from the first end 121a of the first connection body 121. Consequently, the first end 121a of the first connection body 121 is enclosed by the potting wall 126. Preferably, the potting wall 126 is integrally formed with the first end 121a of the first connection body 121. Moreover, the potting wall 126 is made of the insulating material.

The protective cap 127 comprises at least one fourth opening 127a. The at least one first wire 122 is penetrated through the corresponding fourth opening 127a. Moreover, the protective cap 127 is coupled with the potting wall 126. Consequently, the protective stopper 125 is tightly fixed within the potting wall 126. The protective cap 127 is made of an insulating material.

In an embodiment, the first connection body 121 further comprises a first engaging element 128, and the protective cap 127 comprises a second engaging element 129. The first engaging element 128 and the second engaging element 129 are engaged with each other. Consequently, the protective cap 127 is fixed on the first connection body 121.

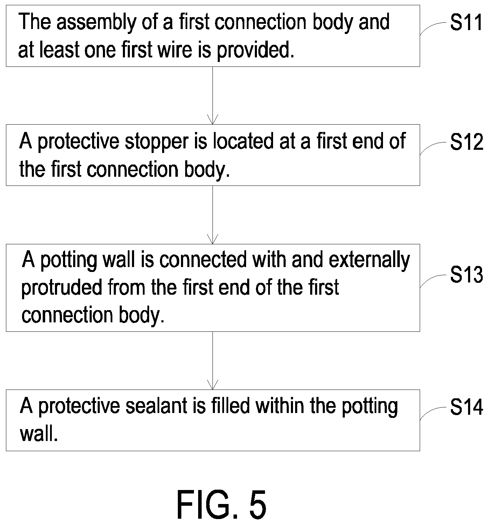

FIG. 5 is a flowchart illustrating a method of fabricating the first connector of the electric apparatus as shown in FIG. 1. Please refer to FIGS. 2A to 2D and FIG. 5. Firstly, in a step S11, the assembly of the first connection body 121 and the at least one first wire 122 is provided. The connecting relationship between the first connection body 121 and the at least one first wire 122 is identical to that of FIG. 2A, and is not redundantly described herein. In a step S12, a protective stopper 123a is provided. The protective stopper 123a is located at the first end 121a of the first connection body 121. The wire-outlet hole 121c and a portion of the first wire 122 close to the first end 121a of the first connection body 121 are covered by the protective stopper 123a. In a step S13, a potting wall 123b is connected with and externally protruded from the first end 121a of the first connection body 121. Consequently, the protective stopper 123a is enclosed by the potting wall 123b. In a step S14, a protective sealant 123c is filled within the potting wall 123b. Meanwhile, the first connector 121 is fabricated.

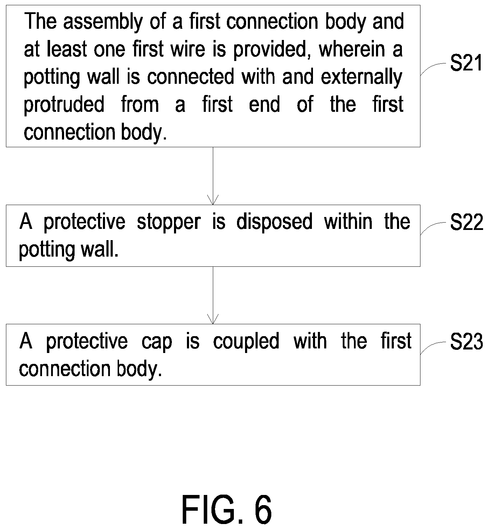

FIG. 6 is a flowchart illustrating a method of fabricating the first connector of the electric apparatus as shown in FIG. 3 Please refer to FIGS. 4A, 4B and 6. Firstly, in a step S21, the assembly of the first connection body 121 and the at least one first wire 122 is provided. The connecting relationship between the first connection body 121 and the at least one first wire 122 is identical to that mentioned above, and is not redundantly described herein. Moreover, a potting wall 126 is connected with and externally protruded from the first end 121a of the first connection body 121. In a step S22, a protective stopper 125 is disposed within the potting wall 126 and the at least one first wire 122 is penetrated through the corresponding third opening 125a of the protective stopper 125. The wire-outlet hole 121c and a portion of the first wire 122 close to the first end 121a of the first connection body 121 are covered by the protective stopper 125. In a step S23, a protective cap 127 is coupled with the first connection body 121. Consequently, the protective stopper 125 is tightly fixed within the potting wall 126. Meanwhile, the first connector 121 is fabricated.

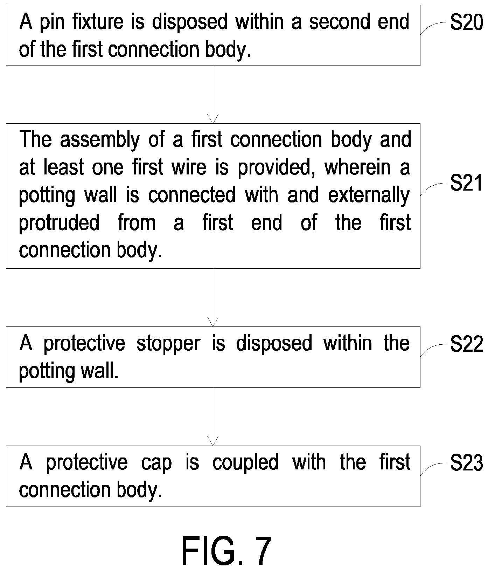

FIG. 7 is a flowchart illustrating a method of fabricating the first connector of the electric apparatus as shown in FIG. 3 according to an example of the present disclosure. In comparison with the example of FIG. 6, the fabricating method further comprises a step S20 before the step S21. In the step S20, a pin fixture 124 is disposed within the second end 121b of the first connection body 121. In some embodiments, in the step S22, the protective stopper 125 is attached to one end of the pin fixture 124.

From the above descriptions, the present disclosure provides an electric apparatus with an electric connection and protection function and a connector of the electric apparatus. The electric apparatus comprises a wall-mount connector. The vacant spaces between the wire-outlet holes of the connector and the wires are sealed. Since the inside and outside of the connector are isolated, the waterproof, temperature-resistant and heat-insulation functions can be achieved. Since the junction between the internal pins of the connector and the wires is not suffered from a rusting problem or a short-circuited problem caused by the ambient moisture, the connecting condition and the operating condition of the electric apparatus are more stable. In such way, the electric apparatus can be applied to the specific environment such as an outdoor low-temperature environment or a high humidity environment. The present disclosure provides a method of fabricating the connector in the cost-effective, simplified and mass-production manners.

## Claims

1. An electric apparatus (1, 1a) with an electric connection and protection function, the electric apparatus (1, 1a) comprises:
a casing (11) comprising at least one first opening (114);
a first connector (12) partially embedded in the first opening (114) and fixed on the casing (11), wherein the first connector (12) comprises a first connection body (121), at least one first wire (122), a protection device (123) and at least one first pin, wherein the first connection body (121) has a first end (121a) and a second end (121b), the at least one first pin is disposed within the first connection body (121), a first end of the first wire (122) is connected with the corresponding first pin and the first wire (122) is routed from the first end (121a) of the first connection body (121), the protection device (123) is disposed on the first end (121a) of the first connection body (121), and the first end (121a) of the first connection body (121) and a portion of the at least one first wire (122) are sealed and covered by the protection device (123), wherein the first end (121a) of the first connection body (121) is disposed within the casing (11), the second end (121b) of the first connection body (121) is located outside the casing (11), and a portion of the first connection body (121) is embedded within the first opening (114) of the casing (11); and
at least one electronic component (14) disposed within the casing (11) and electrically connected with a second end of the at least one first wire (122);
wherein at least one wire-outlet hole (121c) and a portion of the at least one first wire (122) close to the first end (121a) of the first connection body (121) are covered and sealed by the protection device (123), so that a vacant space formed between the at least one wire-outlet hole (121c) and the corresponding first wire (122) is sealed;
wherein the protection device (123) comprises:
a protective stopper (123a) located at the first end (121a) of the first connection body (121), wherein a first side of the protective stopper (123a) is arranged beside the first end (121a) of the first connection body (121), so that the at least one wire-outlet hole (121c) is sealed by the protective stopper (123a), wherein the protective stopper (123a) comprises at least one second opening (123e), and the at least one first wire (122) is penetrated through the corresponding second opening (123e);
**characterized in that** the protective device (123) further comprises
a potting wall (123b) connected with and protruded externally from the first end (121a) of the first connection body (121) to enclose the first end (121a) of the first connection body (121), wherein the protective stopper (123a) is disposed within the potting wall (123b); and
a protective sealant (123c) filled within the potting wall (123b), and arranged beside a second side of the protective stopper (123a), wherein the second side is opposite to the first side.

2. The electric apparatus (1, 1a) according to claim 1, wherein the first connector (12) is a wall-mount connector, and the first connector (12) is penetrated through the first opening (114) of the casing (11) and fixed on the casing (11).

3. The electric apparatus (1, 1a) according to claim 1, wherein the first connection body (121) comprises the at least one wire-outlet hole (121c) located at the first end (121a) thereof, a junction between the first wire (122) and the corresponding first pin is disposed within the first connection body (121), and the at least one first wire (122) is routed from the corresponding wire-outlet hole (121c).

4. The electric apparatus (1, 1a) according to claim 1, wherein the electric apparatus (1, 1a) further comprises a second connector (13), and the second connector (13) is coupled with the first connector (11), wherein the second connector (13) comprises a second connection body (131), at least one second wire (132) and at least one second pin, wherein the at least one second pin is disposed within the second connection body (131), a first end of the at least one second wire (132) is connected with the corresponding second pin, and a second end of the at least one second wire (132) is connected with an electronic system.

## Patentansprüche

1. Elektrische Vorrichtung (1, 1a) mit einer elektrischen Verbindung und einer Schutzfunktion, wobei die elektrische Vorrichtung (1, 1a) umfasst:
ein Gehäuse (11) mit mindestens einer ersten Öffnung (114);
einer ersten Verbindung (12), die teilweise in der ersten Öffnung (114) eingebettet und an dem Gehäuse (11) befestigt ist, wobei die erste Verbindung (12) einen ersten Verbindungskörper (121), mindestens einen ersten Draht (122), eine Schutzeinrichtung (123) und mindestens einen ersten Stift umfasst, wobei der erste Verbindungskörper (121) ein erstes Ende (121a) und ein zweites Ende (121b) aufweist, der mindestens eine erste Stift in dem ersten Verbindungskörper (121) angeordnet ist, ein erstes Ende des ersten Drahts (122) mit dem zugehörigen ersten Stift verbunden ist und der erste Draht (122) von dem ersten Ende (121a) des ersten Verbindungskörpers (121) weggeführt ist, die Schutzeinrichtung (123) an dem ersten Ende (121a) des ersten Verbindungskörpers (121) vorgesehen ist, und das erste Ende (121a) des ersten Verbindungskörpers (121) und ein Teil des mindestens einen ersten Drahts (122) durch die Schutzeinrichtung (123) abgedichtet und abgedeckt sind, wobei das erste Ende (121a) des ersten Verbindungskörpers (121) in dem Gehäuse (11) vorgesehen ist, das zweite Ende (121b) des ersten Verbindungskörpers (121) außerhalb des Gehäuses (11) vorgesehen ist, und ein Teil des ersten Verbindungskörpers (121) in der ersten Öffnung (114) des Gehäuses (11) eingebettet ist; und
mindestens eine elektronische Komponente (14), die in dem Gehäuse (11) angeordnet und elektrisch mit einem zweiten Ende des mindestens einen ersten Drahts (122) verbunden ist;
wobei mindestens ein Draht-Auslassloch (121c) und ein Teil des mindestens einen ersten Drahtes (122) nahe dem ersten Ende (121a) des ersten Verbindungskörpers (121) durch die Schutzeinrichtung (123) abgedeckt und abgedichtet sind, so dass ein freier Raum, der zwischen dem mindestens einen Draht-Auslassloch (121c) und dem zugehörigen ersten Draht (122) gebildet ist, abgedichtet ist;
wobei die Schutzeinrichtung (123) umfasst:
einen Schutzstopper (123a), der an dem ersten Ende (121a) des ersten Verbindungskörpers (121) angeordnet ist, wobei eine erste Seite des Schutzstoppers (123a) neben dem ersten Ende (121a) des ersten Verbindungskörpers (121) angeordnet ist, so dass das mindestens eine Draht-Auslassloch (121c) durch den Schutzstopper (123a) abgedichtet ist, wobei der Schutzstopper (123a) mindestens eine zweite Öffnung (123e) aufweist, und der mindestens eine erste Draht (122) durch die zugehörige zweite Öffnung (123e) hindurchgeführt ist;
**dadurch gekennzeichnet, dass** die Schutzeinrichtung (123) ferner umfasst:
eine Vergusswand (123b), die mit dem ersten Ende (121a) des ersten Verbindungskörpers (121) verbunden ist und von diesem nach außen vorsteht, um das erste Ende (121a) des ersten Verbindungskörpers (121) zu umschließen, wobei der Schutzstopper (123a) innerhalb der Vergusswand (123b) angeordnet ist; und
ein schützendes Dichtungsmittel (123c), das in die Vergusswand (123b) gefüllt und neben einer zweiten Seite des Schutzstoppers (123a) vorgesehen ist, wobei die zweite Seite der ersten Seite gegenüberliegt.

2. Elektrische Vorrichtung (1, 1a) nach Anspruch 1, wobei die erste Verbindung (12) eine wandmontierte Verbindung ist, und wobei die erste Verbindung (12) durch die erste Öffnung (114) des Gehäuses (11) hindurchgeführt und an dem Gehäuse (11) befestigt ist.

3. Elektrische Vorrichtung (1, 1a) nach Anspruch 1, wobei der erste Verbindungskörper (121) das mindestens eine Draht-Auslassloch (121c) umfasst, das sich an dem ersten Ende (121a) davon befindet, sich ein Übergang zwischen dem ersten Draht (122) und dem zugehörigen ersten Stift in dem ersten Verbindungskörpers (121) befindet, und der mindestens eine erste Draht (122) aus dem zugehörigen Draht-Auslassloch (121c) weggeführt ist.

4. Elektrische Vorrichtung (1, 1a) nach Anspruch 1, wobei die elektrische Vorrichtung (1, 1a) außerdem eine zweite Verbindung (13) umfasst, und die zweite Verbindung (13) mit der ersten Verbindung (11) gekoppelt ist, wobei die zweite Verbindung (13) einen zweiten Verbindungskörper (131), mindestens einen zweiten Draht (132) und mindestens einen zweiten Stift aufweist, wobei der mindestens eine zweite Stift in dem zweiten Verbindungskörpers (131) angeordnet ist, ein erstes Ende des mindestens einen zweiten Drahts (132) mit dem zugehörigen zweiten Stift verbunden ist, und ein zweites Ende des mindestens einen zweiten Drahts (132) mit einem elektronischen System verbunden ist.

## Revendications

1. Appareil électrique (1, 1a) ayant une fonction de connexion électrique et de protection, l'appareil électrique (1, 1a) comprenant:
un boîtier (11) comprenant au moins une première ouverture (114);
un premier connecteur (12) partiellement incorporé dans la première ouverture (114) et fixé sur le boîtier (11), dans lequel le premier connecteur (12) comprend un premier corps de connexion (121), au moins un premier fil électrique (122), un dispositif de protection (123) et au moins une première broche, dans lequel le premier corps de connexion (121) a une première extrémité (121a) et une deuxième extrémité (121b), ladite au moins une première broche est placée dans le premier corps de connexion (121), une première extrémité du premier fil (122) est reliée à la première broche correspondante et le premier fil (122) est acheminé depuis la première extrémité (121a) du premier corps de connexion (121), le dispositif de protection (123) est placé sur la première extrémité (121a) du premier corps de connexion (121), et la première extrémité (121a) du premier corps de connexion (121) et une partie dudit au moins un premier fil (122) sont scellées et couvertes par le dispositif de protection (123), dans lequel la première extrémité (121a) du premier corps de connexion (121) est placée dans le boîtier (11), la deuxième extrémité (121b) du premier corps de connexion (121) est située à l'extérieur du boîtier (11), et une partie du premier corps de connexion (121) est incorporée dans la première ouverture (114) du boîtier (11); et
au moins un composant électronique (14) placé dans le boîtier (11) et connecté électriquement à une deuxième extrémité dudit au moins un premier fil (122);
dans lequel au moins un trou de sortie de fil (121c) et une partie dudit au moins un premier fil (122) près de la première extrémité (121a) du premier corps de connexion (121) sont recouverts et scellés par le dispositif de protection (123), de sorte qu'un espace vide formé entre ledit au moins un trou de sortie de fil (121c) et le premier fil correspondant (122) est scellé;
dans lequel le dispositif de protection (123) comprend:
une butée protectrice (123a) située à la première extrémité (121a) du premier corps de connexion (121), dans laquelle un premier côté de la butée protectrice (123a) est placé près de la première extrémité (121a) du premier corps de connexion (121), de sorte que ledit au moins un trou de sortie de fil (121c) est scellé par la butée protectrice (123a), dans laquelle la butée protectrice (123a) comprend au moins une deuxième ouverture (123e), et ledit au moins un premier fil (122) est introduit dans la deuxième ouverture correspondante (123e) ;
**caractérisé en ce que** le dispositif de protection (123) comprend en outre:
une paroi de remplissage (123b) connectée à et faisant saillie extérieurement depuis la première extrémité (121a) du premier corps de connexion (121) pour enfermer la première extrémité (121a) du premier corps de connexion (121), dans laquelle la butée protectrice (123a) est placée à l'intérieur de la paroi de remplissage (123b); et
un produit d'étanchéité protecteur (123c) à l'intérieur de la paroi de remplissage (123b), et placé à côté d'un deuxième côté de la butée protectrice (123a), le deuxième côté étant opposé au premier côté.

2. Appareil électrique (1, 1a) selon la revendication 1, dans lequel le premier connecteur (12) est un connecteur monté sur paroi, et le premier connecteur (12) est introduit par la première ouverture (114) du boîtier (11) et est fixé sur le boîtier (11).

3. Appareil électrique (1, 1a) selon la revendication 1, dans lequel le premier corps de connexion (121) comprend ledit au moins un trou de sortie de fil (121c) situé à la première extrémité (121a) de celui-ci, une jonction entre le premier fil (122) et la première broche correspondante est placée dans le premier corps de connexion (121), et ledit au moins un premier fil (122) est acheminé depuis le trou de sortie de fil correspondant (121c).

4. Appareil électrique (1, 1a) selon la revendication 1, dans lequel l'appareil électrique (1, 1a) comprend en outre un deuxième connecteur (13), et le deuxième connecteur (13) est accouplé au premier connecteur (11), dans lequel le deuxième connecteur (13) comprend un deuxième corps de connexion (131), au moins un deuxième fil (132) et au moins une deuxième broche, dans lequel ladite au moins une deuxième broche est placée dans le deuxième corps de connexion (131), une première extrémité dudit au moins un deuxième fil (132) est connectée à la deuxième broche correspondante, et une deuxième extrémité dudit au moins un deuxième fil (132) est connectée à un système électronique.
